# EUROPEAN PATENT APPLICATION

(11) **EP 4 807 780 A1**
(43) Date of publication of application: **16.09.2026**
(21) Application number: 24902571.9
(22) Date of filing: 28.11.2024
(51) Int. Cl.: H01J 37/32, H01L 21/3065

(54) **PROCESS CHAMBER, UPPER ELECTRODE DEVICE THEREOF, AND SEMICONDUCTOR PROCESS EQUIPMENT**

(30) Priority: 12.12.2023 CN 202311707789
(71) Applicant: Beijing NAURA Microelectronics Equipment Co., Ltd., Beijing 100176 (CN)
(72) Inventor: ZUO, Jie, Beijing 100176 (CN)
(74) Representative: Cohausz & Florack
(86) International application number: PCT/CN2024/135143
(87) International publication number: WO 2025/124149

(57) **Abstract**

The present disclosure provides a process chamber, an upper electrode device thereof, and a semiconductor process equipment. The upper electrode device includes a radio frequency coil and a variable capacitor, where the radio frequency coil is configured to be wound outside a shielding cylinder of the process chamber, and the shielding cylinder is sleeved outside a plasma generation chamber of the process chamber; the variable capacitor is connected in series with the radio frequency coil, and the variable capacitor is configured to be adjusted to different capacitance values in an ignition stage and a reaction stage of the process chamber. The above solution can take into consideration both solving difficult ignition and bombardment of a dielectric window by plasma, and can also mitigate a problem that abnormal discharge is easily caused when the radio frequency coil adopts a lifting structure.

## Description

### TECHNICAL FIELD

The present disclosure belongs to the technical field of semiconductor equipment, and specifically relates to a process chamber, an upper electrode device thereof, and a semiconductor process equipment.

### BACKGROUND

In an inductively coupled plasma device, a radio frequency power supply loads radio frequency power onto a radio frequency coil, and further dissociates process gas in a plasma generation chamber into plasma through an alternating electromagnetic field formed by the radio frequency coil. In this process, coupling of the radio frequency power into the plasma generation chamber is mainly inductive coupling, supplemented by capacitive coupling. Due to the existence of capacitive coupling, after the plasma is formed, an electric field formed by the radio frequency coil is coupled into the plasma generation chamber, thereby causing a relatively large potential difference between the radio frequency coil and the plasma. The relatively large potential difference accelerates the plasma in a sheath located in the plasma generation chamber, such that the plasma accelerates bombardment of a dielectric window of the plasma generation chamber, thereby shortening the service life of the plasma generation chamber. In order to reduce the potential difference, this requires the electric field coupled by the radio frequency coil into the plasma generation chamber to be as small as possible.

However, in a process in which plasma is formed in the plasma generation chamber, the radio frequency coil needs to couple a relatively large electric field into the plasma generation chamber to achieve ignition. If ignition is unsuccessful, plasma cannot be formed. However, if successful ignition is needed, the voltage of the radio frequency coil is relatively large, which in turn causes a relatively large potential difference to be formed between the radio frequency coil and the plasma, resulting in the relatively large electric field driving the plasma to bombard the dielectric window. Thus, it can be seen that, in the related art, solving a problem of difficult ignition and reducing bombardment of the plasma on the plasma generation chamber have become a contradiction that is difficult to reconcile, and how to overcome this contradiction is an important problem to be urgently solved by those skilled in the related art.

### SUMMARY

The present disclosure provides a process chamber, an upper electrode device thereof, and a semiconductor process equipment, so as to solve a problem in the related art that difficult ignition and bombardment of plasma on a dielectric window cannot both be taken into consideration.

In order to solve the above technical problem, the present disclosure provides the following technical solutions:
In a first aspect, an embodiment of the present disclosure provides an upper electrode device for a process chamber, where the disclosed upper electrode device includes a radio frequency coil and an impedance adjustment member, the radio frequency coil is configured to be wound outside a shielding cylinder of the process chamber, and the shielding cylinder is sleeved outside a plasma generation chamber of the process chamber;
The impedance adjustment member is connected in series with the radio frequency coil, and the impedance adjustment member is configured to be adjusted to different impedance values in an ignition stage and a reaction stage of the process chamber.

In a second aspect, an embodiment of the present disclosure provides a process chamber, where the disclosed process chamber includes a plasma generation chamber, a process reaction chamber, a shielding cylinder, and the above upper electrode device, and the process reaction chamber is in communication with the plasma generation chamber.

In a third aspect, an embodiment of the present disclosure provides a semiconductor process equipment, where the disclosed semiconductor process equipment includes a controller and the above process chamber, the controller includes a memory and a processor, the memory stores a computer program, and the processor executes the following operations according to the computer program:
Adjusting the impedance adjustment member to a first preset impedance value;
Loading radio frequency power onto the radio frequency coil, and determining whether ignition is successful;
When ignition is successful, adjusting the impedance adjustment member to a second preset impedance value, where the second preset impedance value is less than the first preset impedance value.

The technical solutions adopted in the present disclosure can achieve the following technical effects:
In the process chamber disclosed in the embodiments of the present disclosure, by improving a structure of the upper electrode device, by additionally arranging an impedance adjustment member of which an impedance value can be adjusted, and by connecting the impedance adjustment member in series with the radio frequency coil, the impedance adjustment member is respectively adjusted to different impedance values in an ignition stage and a process stage, such that the voltage of the radio frequency coil can be adjusted by adjusting the impedance value of the impedance adjustment member. In the ignition stage, the voltage of the radio frequency coil can be relatively large, and further the electric field coupled into the plasma generation chamber can be relatively large, such that ignition can be more easily successful. Meanwhile, in the process stage, the voltage of the radio frequency coil can be adjusted by adjusting the impedance value of the impedance adjustment member, such that the voltage of the radio frequency coil is relatively small, thereby enabling the electric field coupled into the plasma generation chamber to be relatively small, and finally mitigating bombardment of the dielectric window of the plasma generation chamber by the plasma.

Thus, it can be seen that, in the upper electrode device disclosed in the embodiments of the present disclosure, by additionally arranging the impedance adjustment member, and by changing the impedance value of the impedance adjustment member in the ignition stage and the process stage, a contradiction that is relatively difficult to reconcile, namely solving difficult ignition and reducing bombardment of the dielectric window by the plasma, can be solved. Meanwhile, the radio frequency coil does not need to be designed as a lifting structure, and the radio frequency coil can be completely fixedly wound outside the shielding cylinder, thereby avoiding a problem that the radio frequency coil lifting solution is relatively prone to abnormal discharge, and further avoiding occurrence of a problem that corresponding components are relatively easily damaged due to abnormal discharge.

### BRIEF DESCRIPTION OF THE DRAWINGS

The accompanying drawings required for use in descriptions of the embodiments or the related art are briefly introduced below in conjunction with the accompanying drawings. Apparently, the accompanying drawings in the following descriptions are merely some embodiments of the present disclosure. For those of ordinary skill in the art, other accompanying drawings can also be obtained according to these accompanying drawings without creative efforts.
FIG. 1 is a partial structural schematic diagram of a process chamber disclosed in the embodiments of the present disclosure;
FIG. 2 is a cross-sectional view of FIG. 1, where neither FIG. 1 nor FIG. 2 shows a process reaction chamber of the process chamber;
FIG. 3 is a partial structural schematic diagram in FIG. 1;
FIG. 4 is a structural schematic diagram of a shielding cylinder disclosed in the embodiments of the present disclosure;
FIG. 5 and FIG. 6 are respectively structural schematic diagrams of a radio frequency coil and a plasma generation chamber involved in the present disclosure;
FIG. 7 is a circuit schematic diagram of the upper electrode device shown in FIG. 1;
FIG. 8 is a schematic diagram showing influence of the impedance adjustment member on a potential of the radio frequency coil in the upper electrode device shown in FIG. 1;
FIG. 9 is a schematic diagram of an ignition flow disclosed in the embodiments of the present disclosure;
FIG. 10 is a partial structural schematic diagram of another process chamber disclosed in the embodiments of the present disclosure, where FIG. 10 does not show a process reaction chamber of the process chamber;
FIG. 11 is a partial structural schematic diagram in FIG. 10;
FIG. 12 is a partial structural schematic diagram in FIG. 11;
FIG. 13 is a partial structural schematic diagram in FIG. 12;
FIG. 14 is a circuit schematic diagram of the upper electrode device shown in FIG. 10;
FIG. 15 and FIG. 16 are respectively potential distribution diagrams of the radio frequency coil of the upper electrode devices shown in FIG. 1 and FIG. 10 in an ignition stage;
FIG. 17 and FIG. 18 are respectively potential distribution diagrams of the radio frequency coil of the upper electrode devices shown in FIG. 1 and FIG. 10 in a process stage;
FIG. 19 is a schematic diagram of another ignition flow disclosed in the embodiments of the present disclosure;
FIG. 20 is a flowchart of execution operations of a processor of the semiconductor process equipment disclosed in the embodiments of the present disclosure.

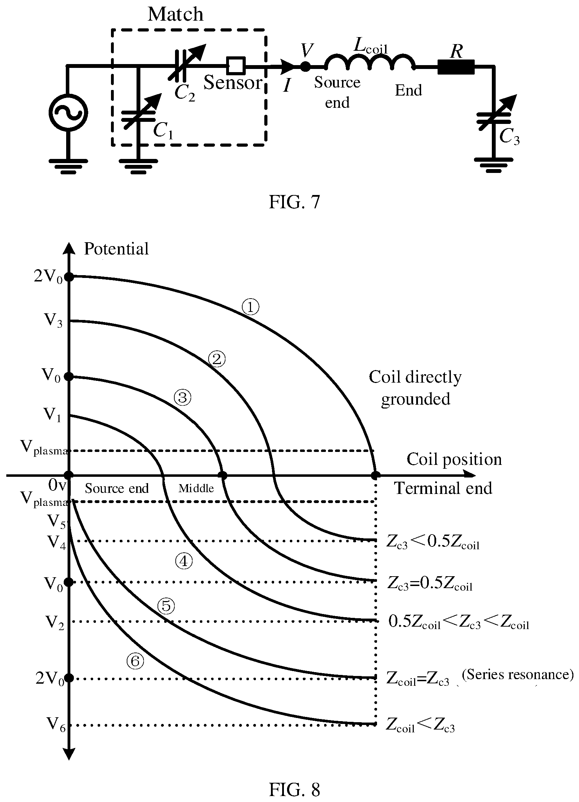

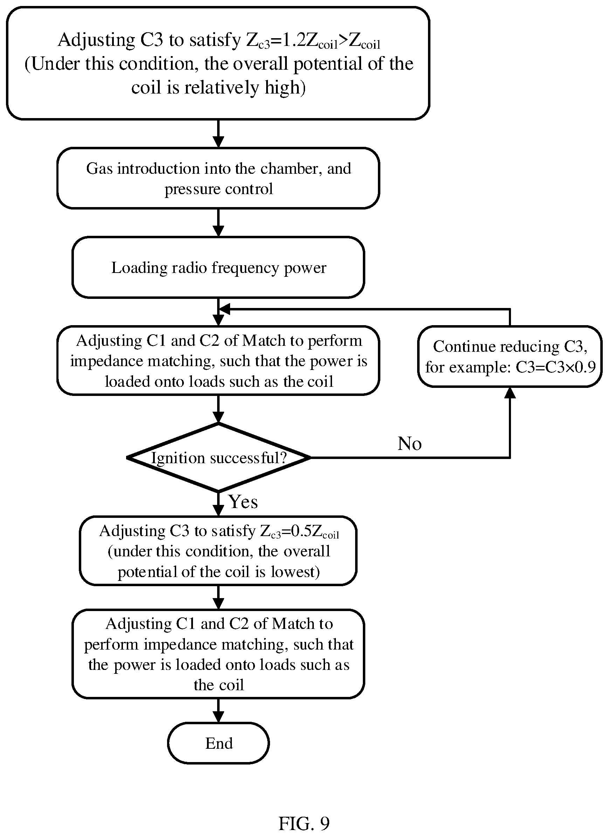

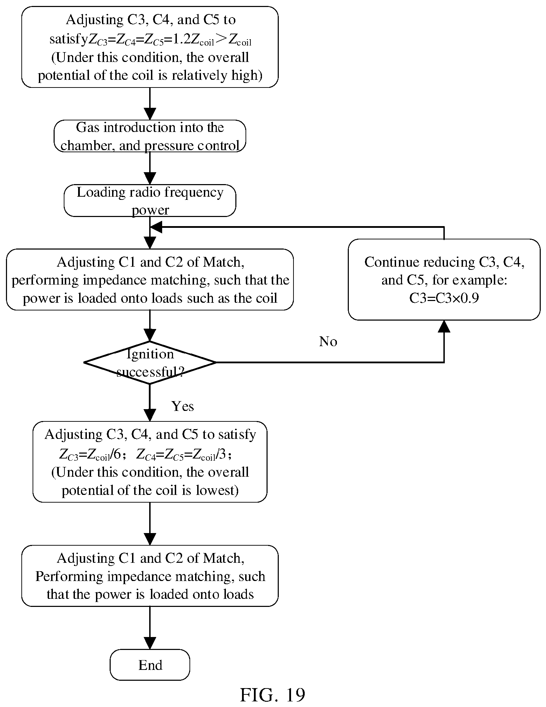

Wherein, the coil in FIG. 8, FIG. 9, and FIG. 19 refers to the radio frequency coil 11, the source end in FIG. 7, FIG. 8, FIG. 14, FIG. 15, FIG. 16, FIG. 17, and FIG. 18 refers to the first end of the radio frequency coil 11, the terminal end refers to the second end of the radio frequency coil 11, and the power in FIG. 9 and FIG. 19 refers to radio frequency power.

### Description of reference numerals:

10-upper electrode device, 11-radio frequency coil, 12-impedance adjustment member, 13-driving mechanism, 121-first sub-impedance adjustment member, 122-second sub-impedance adjustment member,
20-plasma generation chamber, 30-radio frequency power supply, 40-matcher, 50-process gas input pipe, 60-gas spray head, 70-shielding cylinder, 71-slot, 72-flared window, 80-shielding box.

### DETAILED DESCRIPTION OF THE EMBODIMENTS

In order to make the objectives, technical solutions, and advantages of the present disclosure clearer, the technical solutions of the present disclosure are clearly and completely described below in conjunction with specific embodiments of the present disclosure and corresponding accompanying drawings. Apparently, the described embodiments are merely a part of the embodiments of the present disclosure, rather than all embodiments. All other embodiments obtained by those of ordinary skill in the art based on the embodiments in the present disclosure without creative efforts shall fall within the scope of the present disclosure.

The technical solutions disclosed in various embodiments of the present disclosure are described in detail below in conjunction with the accompanying drawings.

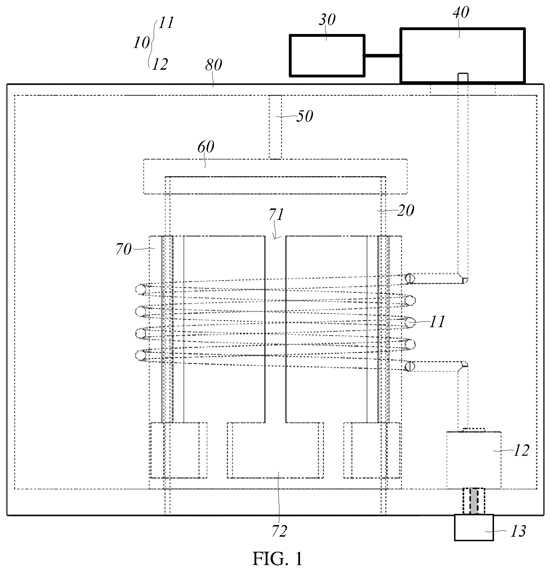

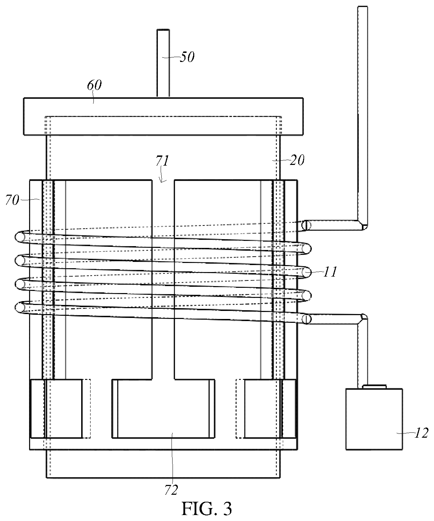

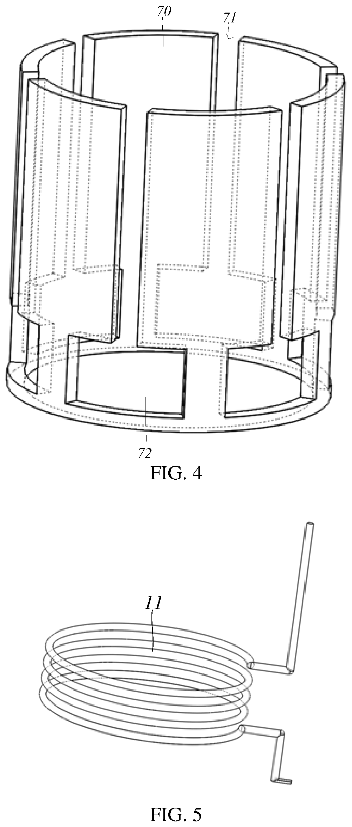

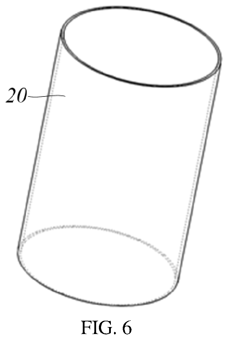

Please refer to FIG. 1 to FIG. 19. An embodiment of the present disclosure provides a process chamber. The disclosed process chamber is at least a part of a semiconductor process equipment. The disclosed process chamber can include an upper electrode device 10, a plasma generation chamber 20, a radio frequency power supply 30, a matcher 40, a process gas input pipe 50, a gas spray head 60, a shielding cylinder 70, a process reaction chamber, or the like.

The upper electrode device 10 includes a radio frequency coil 11. A first end of the radio frequency coil 11 can be electrically connected to the radio frequency power supply 30 through the matcher 40, and the matcher 40 automatically performs impedance matching adjustment. Further, the matcher 40 can be electrically connected to the first end of the radio frequency coil 11 through an electrical connection strip, so as to facilitate electrical connection with the radio frequency coil 11. Certainly, the first end of the radio frequency coil 11 can be directly electrically connected to the matcher 40.

A second end of the radio frequency coil 11 is used for electrical connection with ground. Specifically, the radio frequency coil 11 can be used for directly electrically connecting with ground, or can be indirectly electrically connected with ground through other grounding members, which is not limited in the embodiments of the present disclosure.

A first end of the process gas input pipe 50 can be in communication with a process gas source, and a second end of the process gas input pipe 50 can be in communication with the gas spray head 60 mounted on the plasma generation chamber 20, and is in communication with the plasma generation chamber 20 through the gas spray head 60. Process gas can flow out from the process gas source, then enter the plasma generation chamber 20 along the process gas input pipe 50 and the gas spray head 60, thereby preparing for subsequent formation of plasma in the plasma generation chamber 20. The gas spray head 60 can adopt a structure capable of distributing process gas, such that the process gas is conveyed into the plasma generation chamber 20 as uniformly as possible. The plasma generation chamber 20 can be a dielectric tube made of materials such as quartz and ceramic or the like. The dielectric tube can be cylindrical, and can also have other shapes, which is not limited in the embodiments of the present disclosure.

The shielding cylinder 70 plays a shielding role. The shielding cylinder 70 can be a Faraday cage. The shielding cylinder 70 is sleeved outside the plasma generation chamber 20 to play a certain shielding role. The radio frequency coil 11 is wound outside the shielding cylinder 70. After the radio frequency coil 11 is energized, a magnetic field and an electric field are generated. The shielding cylinder 70 almost does not attenuate the magnetic field coupled into the plasma generation chamber 20, but shields the electric field generated by the radio frequency coil 11, thereby reducing the electric field coupled by the radio frequency coil 11 into the plasma generation chamber 20. That is, the radio frequency coil 11 is not only wound outside the shielding cylinder 70, but is also wound outside the plasma generation chamber 20.

In a specific working process, the radio frequency power supply 30 transmits radio frequency power (which can be understood as radio frequency energy) into the radio frequency coil 11 through the matcher 40, and finally introduces the radio frequency power into ground. Certainly, when the process chamber includes the shielding box 80 described below, the radio frequency power can be transmitted from the radio frequency coil 11 to the shielding box 80, and finally introduced into (radio frequency) ground through the shielding box 80. In this process, the radio frequency coil 11 couples a magnetic field and an electric field into the plasma generation chamber 20. The electric field is applied to the process gas already input into the plasma generation chamber 20, thereby dissociating the process gas to form plasma, and further completing ignition. The magnetic field determines a distribution density of the plasma, and the magnetic field is applied to the plasma such that the density of the plasma satisfies requirements. The process reaction chamber is in communication with the plasma generation chamber 20, and plasma having a density satisfying process requirements enters the process reaction chamber from the plasma generation chamber 20 to participate in a process reaction. The process reaction chamber can be located below the plasma generation chamber 20 and be in communication with the plasma generation chamber 20.

It can be known from the above descriptions that the process gas needs to first form plasma, and then participates in a process reaction. Correspondingly, the process chamber disclosed in the embodiments of the present disclosure needs to undergo an ignition stage and a reaction stage during operation. The reaction stage occurs after completion of the ignition stage. Certainly, normal progress of the reaction stage requires that ignition in the ignition stage can be successful.

The shielding cylinder 70 can shield a part of the electric field of the radio frequency coil 11, and the shielding cylinder 70 is grounded, such that the potential of the shielding cylinder 70 is relatively low, thereby causing a relatively small potential difference between the formed plasma and the shielding cylinder 70, and further causing a relatively small potential difference between the plasma and a dielectric window of the plasma generation chamber 20 (the dielectric window is located between the shielding cylinder 70 and the plasma), thereby mitigating bombardment of the dielectric window by the plasma under action of the electric field, and achieving a purpose of prolonging a service life of the plasma generation chamber 20. Optionally, the shielding cylinder 70 can be mounted inside the shielding box 80 described below, and can be electrically connected with the shielding box 80, and is finally grounded through the shielding box 80.

Before the process gas forms plasma, ignition needs to be performed, that is, the process chamber described above undergoes an ignition stage during operation. The inventors of the present disclosure found during implementation of the present disclosure that, although the shielding cylinder 70 can play a shielding role so as to avoid bombardment of the plasma generation chamber 20 by plasma, the shielding cylinder 70 also reduces the electric field coupled by the radio frequency coil 11 into the plasma generation chamber 20. However, in the ignition stage, the radio frequency coil 11 needs to increase capacitive coupling, thereby causing more electric field to be coupled into the plasma generation chamber 20 so as to achieve glow discharge initiation (that is, ignition) of the process gas, and this requirement is difficult to achieve precisely due to the shielding function of the shielding cylinder 70. In other words, arrangement of the shielding cylinder 70 can indeed mitigate bombardment of the dielectric window by plasma, but causes difficult ignition in the ignition stage, thereby ultimately making ignition more difficult to succeed. However, if the problem of difficult ignition is to be solved, it is necessary to avoid arranging the shielding cylinder 70 as much as possible. Thus, it can be seen that solving difficult ignition and solving bombardment of the plasma generation chamber 20 by plasma have become a contradiction that is relatively difficult to reconcile.

Based on this, in some related technologies, the inventors improve the process chamber such that the radio frequency coil 11 can move up and down relative to the plasma generation chamber 20. This design utilizes Paschen's law. Since ignition voltage is related to discharge distance, increasing a height of the radio frequency coil 11 can change an ignition distance (that is, a discharge distance) between the radio frequency coil 11 and ground, thereby more easily enabling a relatively large voltage to be formed on the radio frequency coil 11 for ignition, and further enabling ignition to be more easily successful. After ignition is successful, the height of the radio frequency coil 11 is reduced again, such that the radio frequency coil 11 is closer to the process reaction chamber, thereby ensuring efficiency of the process reaction.

However, regarding this solution, the inventors further found that the current of the radio frequency coil 11 is relatively large, and an electrical connection strip connecting the radio frequency coil 11 with the matcher 40 or the radio frequency power supply 30 is generally relatively wide and rigid. The radio frequency coil 11 carries an extremely high voltage. If virtual connection occurs between the electrical connection strip and the radio frequency coil 11, abnormal discharge at a contact point is relatively likely to occur, thereby causing damage to components (the radio frequency coil 11 and the electrical connection strip) and process failure. In order to avoid abnormal discharge, the electrical connection strip and the radio frequency coil 11 need to be connected in a manner of good rigid contact, which determines that the radio frequency coil 11 needs to be fixedly mounted. Apparently, this causes the radio frequency coil 11 to be relatively difficult to design as a movable structure capable of moving up and down. Next, the voltage of the radio frequency coil 11 is usually several kilovolts or even tens of thousands of volts, and the shielding cylinder 70 is grounded. In order to ensure coupling efficiency, a distance between the radio frequency coil 11 and the shielding cylinder 70 is not excessively large, and is only several millimeters to more than ten millimeters. Therefore, withstand voltage design between the radio frequency coil 11 and the shielding cylinder 70 needs to be specially considered, and abnormal discharge is relatively likely to occur between the radio frequency coil 11 and the shielding cylinder 70 during an up-and-down movement process. Thus, it can be seen that the up-and-down movement design of the radio frequency coil 11 has relatively high requirements on withstand voltage design. If slight carelessness occurs, arc creeping discharge is extremely likely to occur between the radio frequency coil 11 moving up and down and the shielding cylinder 70, thereby causing damage to components (the radio frequency coil 11 and the shielding cylinder 70). Further, moving the radio frequency coil 11 up and down requires a relatively long time, and further causes load impedance of the matcher 40 to change, such that the matcher 40 needs to perform impedance matching again, ultimately causing the entire ignition stage to consume a relatively long time, and ultimately causing relatively low productivity of the process chamber.

Based on the various problems listed above, the inventors of the present disclosure further improve the structure of the process chamber, such that the upper electrode device 10 involved in the embodiments of the present disclosure can further include an impedance adjustment member.

In the embodiments of the present disclosure, the impedance adjustment member is connected in series with the radio frequency coil 11. The impedance adjustment member is configured to be adjusted to different impedance values in the ignition stage and the reaction stage of the process chamber. In some optional implementations, the impedance adjustment member is an electrical device of which the impedance value can be adjusted, and can be a variable capacitor, where the impedance value thereof is changed by adjusting a capacitance value. In some other optional implementations, the impedance adjustment member can also be a variable inductor, where the impedance value thereof is changed by adjusting an inductance value. The present disclosure does not limit this, as long as the impedance adjustment member can adjust its own impedance.

In the following, the upper electrode device 10 in the embodiments of the present disclosure is specifically described by taking the impedance adjustment member being the variable capacitor 12 as an example:

As shown in FIG. 1, the variable capacitor 12 is connected in series with the radio frequency coil 11. The variable capacitor 12 is configured to be adjusted to different capacitance values in the ignition stage and the reaction stage of the process chamber. In this case, in the ignition stage, the capacitance value of the variable capacitor 12 is adjusted, such that the impedance value thereof is correspondingly changed, thereby enabling the voltage of the radio frequency coil 11 to be adjusted to a relatively high voltage after the matcher 40 performs impedance matching adjustment. Therefore, even after a part of the electric field generated by the radio frequency coil 11 is shielded by the shielding cylinder 70, a relatively large electric field can still be coupled into the plasma generation chamber 20, thereby more easily achieving successful ignition. After the ignition stage is completed and the process stage is entered, in order to avoid excessive coupling of the electric field generated by the radio frequency coil 11 into the plasma generation chamber 20, the capacitance value of the variable capacitor 12 is further adjusted, such that the impedance value thereof is also further changed, thereby enabling the voltage of the radio frequency coil 11 to be adjusted to a relatively low voltage after the matcher 40 performs impedance matching adjustment. Therefore, after a part of the electric field generated by the radio frequency coil 11 is shielded by the shielding cylinder 70, the electric field capable of being coupled into the plasma generation chamber 20 is already relatively small, and plasma is also not caused to bombard the plasma generation chamber 20 under driving of a relatively large electric field.

Specifically, in the ignition stage, the capacitance value of the variable capacitor 12 can be adjusted to a first capacitance value (that is, the impedance value of the impedance adjustment member is correspondingly adjusted to a first impedance value), and the matcher 40 performs impedance matching adjustment according to the first capacitance value, such that the voltage of the radio frequency coil 11 is adjusted to a first voltage, where the first voltage is greater than an ignition voltage. It should be noted that, herein, the ignition voltage refers to a voltage corresponding to successful ignition, and the embodiments of the present disclosure do not limit a specific numerical value of the ignition voltage. In the reaction stage, the capacitance value of the variable capacitor 12 is adjusted to a second capacitance value (that is, the impedance value of the impedance adjustment member is correspondingly adjusted to a second impedance value), and the matcher 40 performs impedance matching adjustment according to the second capacitance value, such that the voltage of the radio frequency coil 11 is adjusted to a second voltage, where the second voltage is less than the ignition voltage, thereby avoiding coupling of a relatively large electric field into the plasma generation chamber 20. Wherein, the first capacitance value is less than the second capacitance value (that is, the first impedance value is greater than the second impedance value).

In the process chamber disclosed in the embodiments of the present disclosure, by improving the structure of the upper electrode device 10, by additionally arranging the variable capacitor 12 of which the capacitance value can be adjusted, and by connecting the variable capacitor 12 in series with the radio frequency coil 11, the variable capacitor 12 is respectively adjusted to different capacitance values in the ignition stage and the process stage, thereby enabling the voltage of the radio frequency coil 11 to be adjusted by adjusting the capacitance value of the variable capacitor 12. Therefore, in the ignition stage, the voltage of the radio frequency coil 11 can be relatively large, and further the electric field coupled into the plasma generation chamber 20 can be relatively large (that is, capacitive coupling is increased such that the electric field coupled into the plasma generation chamber 20 is relatively strong), thereby making ignition more easily successful. Meanwhile, in the process stage, the voltage of the radio frequency coil 11 can be adjusted by adjusting the capacitance value of the variable capacitor 12, such that the voltage of the radio frequency coil 11 is relatively small, thereby enabling the electric field coupled into the plasma generation chamber 20 to be relatively small (that is, capacitive coupling is reduced such that the electric field coupled into the plasma generation chamber 20 is relatively weak), and ultimately mitigating bombardment of the dielectric window of the plasma generation chamber 20 by plasma.

Thus, it can be seen that, in the upper electrode device 10 disclosed in the embodiments of the present disclosure, by additionally arranging the impedance adjustment member, for example, the variable capacitor 12, and by changing the capacitance value of, for example, the variable capacitor 12 in the ignition stage and the process stage (that is, changing the impedance value of the impedance adjustment member), a contradiction that is relatively difficult to reconcile, namely difficult ignition and reduction of bombardment of the dielectric window by plasma, can be solved. Meanwhile, the radio frequency coil 11 does not need to be designed as a lifting structure, and the radio frequency coil 11 can be completely fixedly wound outside the shielding cylinder 70, thereby avoiding occurrence of a problem that corresponding components are relatively easily damaged due to relatively easy abnormal discharge existing in a solution in which the radio frequency coil 11 moves up and down.

As described above, the impedance adjustment member is connected in series with the radio frequency coil 11. Specifically, there are multiple series connection manners of the impedance adjustment member and the radio frequency coil 11. In one optional solution, similarly by taking the impedance adjustment member being the variable capacitor 12 as an example, the first end of the radio frequency coil 11 is used for electrical connection with the radio frequency power supply 30, and the second end of the radio frequency coil 11 is used for grounding. The variable capacitor 12 can be connected between the second end of the radio frequency coil 11 and ground, thereby realizing series connection with the radio frequency coil 11. In this design manner, the variable capacitor 12 is connected between the second end of the radio frequency coil 11 and ground, thereby conveniently ensuring integrity of the radio frequency coil 11 (that is, the radio frequency coil 11 can be formed by winding a whole wire rod), and simultaneously avoiding relatively large modification to the radio frequency coil 11 as much as possible. That is, the variable capacitor 12 only needs to be added between the second end and ground on the basis of the radio frequency coil 11 of the process chamber in the related art, such that modification is relatively small and implementation is easy.

Further, the number of impedance adjustment members can be one or at least two, and the embodiments of the present disclosure do not limit the number of the impedance adjustment members. Certainly, when at least two impedance adjustment members are connected in series between the second end of the radio frequency coil 11 and ground, these impedance adjustment members can be connected in series or in parallel between the second end of the radio frequency coil 11 and ground.

Specifically, by taking the impedance adjustment member being one variable capacitor 12 as an example, the radio frequency coil 11 can be formed by winding a whole wire rod, and the variable capacitor 12 is connected between the second end of the radio frequency coil 11 and ground. The impedance value of the variable capacitor 12 in the ignition stage can be greater than *Z_{coil}*, for example, 1.2*Z_{coil}*. The impedance value of the variable capacitor 12 in the reaction stage can be greater than 0 and less than *Z_{coil}*. Optionally, the impedance value of the variable capacitor 12 in the reaction stage is greater than 0.4Z_{coil} and less than 0.6Z_{coil}. In a still further optional solution, the impedance value of the variable capacitor 12 in the reaction stage is equal to 0.5*Z_{coil}*, where *Z_{coil}* is the impedance value of the radio frequency coil 11. This optional solution more easily takes into consideration both solving difficult ignition and bombardment of the plasma generation chamber 20 by plasma. The following provides detailed description in conjunction with FIG. 7 and FIG. 8.

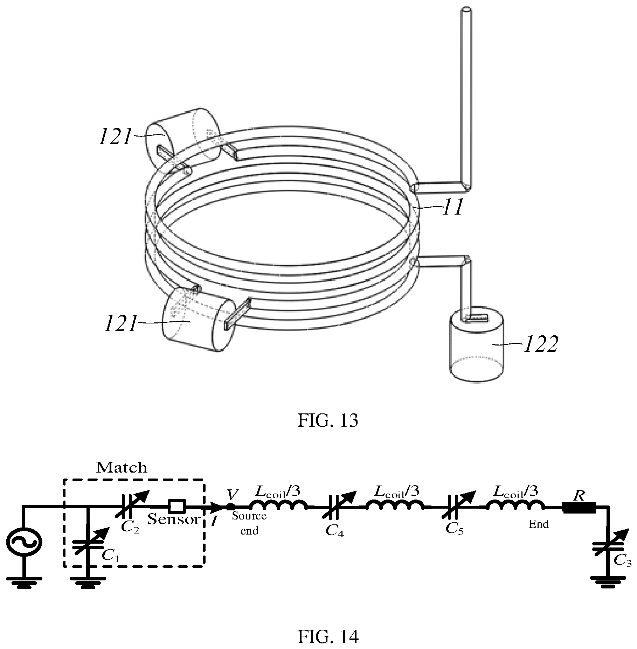

In FIG. 7 and FIG. 13, the matcher (that is, Match in FIG. 7, FIG. 9, FIG. 14, and FIG. 19) 40 can adopt a mature and general L-type fully automatic matcher currently available on the market. The sensor (Sensor) inside the matcher 40 reads the radio frequency voltage and the radio frequency current, and calculates an impedance value. Through a control program, the capacitance value of the variable capacitor 12 is adjusted, thereby causing impedance of a rear end of the upper electrode device 10 to match impedance of the radio frequency power supply 30 at a front end, so as to ensure that as much radio frequency power as possible (which can also be considered as radio frequency energy) can be transmitted to a rear-end load of the upper electrode device 10 (the rear-end load includes the radio frequency coil 11 and the variable capacitor 12). It should be noted that the matcher 40 herein serves a purpose of impedance matching, and both the structure and the working principle thereof are known mature technologies, and details are not described herein again. Those skilled in the art should understand that the embodiments of the present disclosure can also adopt other types of matchers, and the present disclosure does not make any limitation thereto.

Please first refer to FIG. 7. An inductance of the radio frequency coil 11 is *L_{coil}*, a real-part impedance of loads such as the radio frequency coil 11 is *R*, the variable capacitor 12 connected to the second end of the radio frequency coil 11 is *C*₃, and a first tuning capacitor and a second tuning capacitor of the matcher 40 are respectively *C*₁ and *C*₂. The first tuning capacitor and the second tuning capacitor are used for adjusting the rear-end load impedance to impedance output by the radio frequency power supply 30 (for example, 50Ω), so as to ensure maximum power transmission to the rear-end load. Assuming that current flowing into the radio frequency coil 11 is *I*, the voltage at the source end (that is, the first end of the radio frequency coil 11) of the radio frequency coil 11 is *V*. A voltage-current sensor (Sensor) is provided at an output end of the matcher 40, and can be used for monitoring the potential of the source end of the radio frequency coil 11. The potential of the source end of the radio frequency coil 11 is: $V = I \left(R+{Z}_{coil}+{Z}_{c 3}\right)$

Wherein, impedance of the radio frequency coil 11 is *Z_{coil}* = *j*ω*L_{coil}*", and impedance of the variable capacitor 12 (that is, *C*₃) is ${Z}_{c 3} = \frac{1}{{jωC}_{3}}$. The angular frequency is ω=2*πf* , and *f* is a frequency of an output signal of the radio frequency power supply 30. After the matcher 40 satisfies an impedance matching condition, output power of the radio frequency power supply 30 satisfies *Power*=*I*²*R*, and the potential of the source end of the radio frequency coil 11 is: $V = \sqrt{\frac{Power}{R}} \left(R+{jωL}_{coil}+\frac{1}{{jωC}_{3}}\right)$

In an inductively coupled plasma source, if the structure of the radio frequency coil 11 remains unchanged, the density of plasma is positively correlated with the current of the radio frequency coil 11. The greater the current of the radio frequency coil 11 is, the higher the plasma density is. After adjustment of the capacitance value of the variable capacitor 12 (that is, *C*₃) at the second end of the radio frequency coil 11, and after the matcher 40 adjusts *C*₁ and *C*₂ for rematching, the current value flowing through the radio frequency coil 11 is almost unchanged, and does not affect the density of the excited plasma, but can change voltage distribution on the radio frequency coil 11. By reducing an average potential and a maximum potential on the radio frequency coil 11, capacitive coupling can be reduced, electric field intensity in the sheath can be reduced, and bombardment of the dielectric window by plasma accelerated through the electric field is weakened, thereby mitigating bombardment of the dielectric window of the plasma generation chamber 20 by plasma.

If the structure of the radio frequency coil 11 remains unchanged, impedance *Z_{coil}* of the radio frequency coil 11 remains unchanged; changing the magnitude of the variable capacitor (that is, *C₃*) 12 does not affect the current flowing through the radio frequency coil 11. It should be noted that, for impedance *Z=R+jX*, R is a real-part impedance, and power consumed thereby is active power, and *X* is an imaginary-part impedance, and power consumed thereby is reactive power. Power output by the radio frequency power supply 30 is all active power. The process chamber (for example, an etching machine) generally uses the radio frequency power supply 30 having constant power, and the radio frequency power (that is, *Power*) of the radio frequency power supply 30 has a fixed magnitude. According to *Power=I²R,* changing the magnitude of the variable capacitor (that is, *C*₃) 12 only changes the imaginary-part impedance *X*, and does not affect the magnitude of the real-part impedance *R*, and therefore does not affect the magnitude of the current *I.* Thus, it can be known that a potential difference Δ*V* between two ends of the radio frequency coil 11 is basically the same, and is uniformly denoted herein as: $Δ V = I ⋅ {jωL}_{coil} = 2 {V}_{0}$

Under the same radio frequency power, a potential difference between two ends of the radio frequency coil 11 is 2*V*₀. Influence of different capacitance values of *C*₃ on potential distribution on the radio frequency coil 11 is shown in FIG. 8, and corresponding numerical values are shown in FIG. 8 and Table 1. It can be seen that, when *Z*_{*C*3}>*Z*_{coil}, the average potential and the maximum potential on the radio frequency coil 11 are both relatively large. At this time, the electric field coupled into the plasma generation chamber 20 is strongest, and ignition is most facilitated. When *Z*_{*C*3}=0.5*Z_{coil},* the average potential and the maximum potential on the radio frequency coil 11 are both minimum. At this time, the electric field coupled into the plasma generation chamber 20 is weakest, and bombardment of the plasma generation chamber 20 by plasma in the sheath is weakest.

**Table 1**

| Condition | Impedance condition *Z*_{*C*3} of *C*₃ | Potential of the radio frequency coil | | | |
|---|---|---|---|---|---|
| | | Potential of the source end | Potential of the end | Maximum potential | Average potential |
| ① | *Z*_{*C*3}=0 (Direct grounding) | 2*V*₀ | 0 | 2*V*₀ | $\sqrt{2} {V}_{0}$ |
| ② | *Z_{C3}* < 0.5 *Z*_{coil} | *V*₀ < *V*₃ < 2*V*₀ | 0 <*V*₄ < *V*₀ | *V*₀ < *V*₃ < 2*V*₀ | $\frac{\sqrt{2}}{2} {V}_{0} ∼ \sqrt{2} {V}_{0}$ |
| ③ | *Z*_{*C*3}=0.5 *Z*_{coil} | *V*₀ | *V*₀ | *V*₀ | $\frac{\sqrt{2}}{2} {V}_{0}$ |
| ④ | 0.5 *Z*_{coil} < *Z*_{*C*3} < *Z*_{coil} | 0 <*V*₁ < *V*₀ | *V*₀ < *V*₂ < 2*V*₀ | *V*₀ < *V*₂ < 2*V*₀ | $\frac{\sqrt{2}}{2} {V}_{0} ∼ \sqrt{2} {V}_{0}$ |
| ⑤ | *Z*_{*C*3}=*Z*_{coil}(Series resonance) | 0 | 2*V*₀ | 2*V*₀ | $\sqrt{2} {V}_{0}$ |
| ⑥ | *Z_{C3}* > *Z*_{coil} | 0 < *V*₅ | *V*₆= *V*₅+2*V*₀ | *V*₆= *V*₅+2*V*₀ > 2*V*₀ | $> \sqrt{2} {V}_{0}$ |

According to this characteristic, in condition ⑥ in Table 1, the average potential of the radio frequency coil 11 is highest, and the electric field is strongest, which is beneficial to ignition. The capacitance value setting of the variable capacitor 12 in condition ⑥ can be used for gas ignition to dissociate process gas, such that the process gas forms plasma. In condition ③ in Table 1, the average potential of the radio frequency coil 11 is lowest, and the electric field is weakest. The capacitance value setting of the variable capacitor 12 in condition ③ is relatively suitable for use in a process reaction process (that is, relatively suitable for the reaction stage).

In order to facilitate understanding of the ignition process, please refer to FIG. 9. Before loading radio frequency power, *C₃* is adjusted to satisfy *Z_{C3}*=1.2*Z_{coil}>Z_{coil}.* Certainly, only satisfying *Z_{C3}*>*Z_{coil}* is needed. For example, *Z_{C3}* can actually be preset as 1.1*Z_{coil},* 1.3*Z_{coil},* or the like, but adjustment of the capacitance value of *C₃* cannot exceed a lower limit of a capacitance range of *C₃*. Under this condition, the overall potential of the radio frequency coil 11 is relatively high. After gas introduction and pressure control are performed on the chamber (that is, the plasma generation chamber 20), radio frequency power is loaded, *C*₁ and *C*₂ of Match (that is, the matcher 40) are adjusted, and impedance matching is performed, such that the radio frequency power is loaded onto loads such as the radio frequency coil 11. At this time, the electric field formed by the radio frequency coil 11 is relatively strong, which is beneficial to ignition.

A manner for determining whether ignition is successful is as follows: a voltage-current sensor (that is, Sensor in the figure) is mounted at the output end of Match, and voltage *V*₁ of static impedance at an ignition instant and voltage *V*₂ after glow discharge initiation are collected in advance through manual testing. Since *V*₂ is obviously less than *V*₁, a voltage threshold *V*₀=0.5*V*₁+0.5*V*₂ can be specified. At the ignition instant, Sensor reads voltage *V*. If *V* drops from being greater than *V*₀ to being less than *V*₀, ignition is considered successful. If ignition fails, the value of *C*₃ continues to be reduced (for example, a capacitance value obtained after multiplying the current value of *C₃* by 0.9 is used as the adjusted capacitance value of *C₃*), and matching is performed again until ignition is successful.

After ignition is successful, *C*₃ is adjusted again such that the impedance value of *C*₃ satisfies *Z_{C3}*=0.5*Z_{coil}*. In this case, the overall potential of the radio frequency coil 11 is lowest. Afterwards, Match adjusts *C*₁ and *C*₂ to perform impedance matching, such that the radio frequency power is completely loaded again onto loads such as the radio frequency coil 11, and then the process stage is entered.

As described above, the first end of the radio frequency coil 11 is used for electrical connection with the radio frequency power supply 30 of the process chamber, and the second end of the radio frequency coil 11 is used for grounding. The impedance adjustment member includes at least one first sub-impedance adjustment member. The radio frequency coil includes at least two coil sections connected in series, and each first sub-impedance adjustment member is connected in series between two adjacent coil sections. In a solution of another embodiment, still by taking the impedance adjustment member being the variable capacitor 12 as an example, the variable capacitor 12 can include at least one first sub-variable capacitor 121, and the radio frequency coil 11 can include at least two coil sections connected in series. Each first sub-variable capacitor 121 can be connected in series between two adjacent coil sections. In this case, the radio frequency coil 11 is not one whole wire rod, but multiple separate wire rods (at least two sections). In this case, during a process of adjusting the capacitance value of the variable capacitor 12, the capacitance value of the first sub-variable capacitor 121 can be adjusted, so as to achieve the purpose of the present disclosure.

For example, the radio frequency coil 11 can include two coil sections, one first sub-variable capacitor 121 can be provided, and the first sub-variable capacitor 121 is connected between the two coil sections.

In a more specific technical solution, there are multiple first sub-variable capacitors 121, impedance values of the first sub-variable capacitors 121 are all equal, and are greater than an impedance value of the second sub-variable capacitor 122. As shown in FIG. 9 to FIG. 12, there can be two first sub-variable capacitors 121, the radio frequency coil 11 can include three coil sections, and there can be two first sub-variable capacitors 121, which are respectively connected between two adjacent coil sections.

Further, the impedance adjustment member further includes a second sub-impedance adjustment member, and the second sub-impedance adjustment member is configured to be connected between the second end of the radio frequency coil and ground. Please refer again to FIG. 9 to FIG. 12. In a further technical solution, the variable capacitor 12 can further include a second sub-variable capacitor 122, and the second sub-variable capacitor 122 is configured to be connected between the second end of the radio frequency coil 11 and ground. During a process of adjusting the capacitance value of the variable capacitor 12, capacitance values of the first sub-variable capacitor 121 and the second sub-variable capacitor 122 can be adjusted simultaneously, thereby changing respective impedance values of the first sub-variable capacitor 121 and the second sub-variable capacitor 122, so as to achieve the purpose of the present disclosure.

By taking the impedance adjustment member being the variable capacitor 12 as an example, when the variable capacitor 12 includes the first sub-variable capacitor 121 and the second sub-variable capacitor 122, in the ignition stage, impedance values of the first sub-variable capacitor 121 and the second sub-variable capacitor 122 can both be greater than *Z_{coil}*, for example, 1.2 *Z_{coil}*; and in the reaction stage, the impedance values of the first sub-variable capacitor 121 and the second sub-variable capacitor 122 can both be greater than 0 and less than *Z_{coil}*.

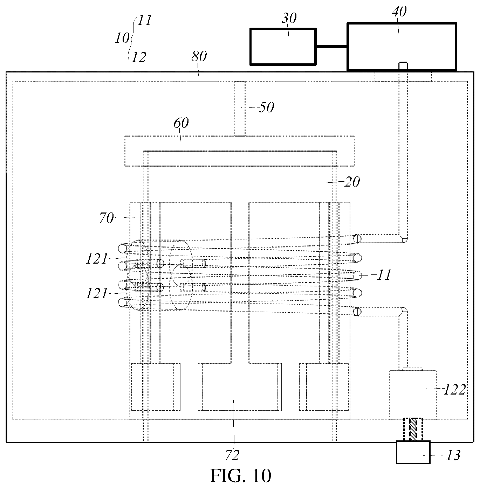

In other embodiments, in the reaction stage, the impedance value of the first sub-variable capacitor 121 can be *Z_{coil}*/n, and the impedance value of the second sub-variable capacitor 122 can be *Z*_{*coil*/}2n. This optional solution more easily takes into consideration both solving difficult ignition and bombardment of the plasma generation chamber 20 by plasma. Wherein, n is a sum of the number of the first sub-variable capacitors 121 and the number of the second sub-variable capacitors 122. Specifically, there are two first sub-variable capacitors 121 and one second sub-variable capacitor 122. In this case, n is 3. Correspondingly, in the reaction stage, the impedance value of the first sub-variable capacitor 121 is *Z_{coil}*/3, and the impedance value of the second sub-variable capacitor 122 is *Z_{coil}*/6. The following provides description in conjunction with FIG. 10 to FIG. 18 together.

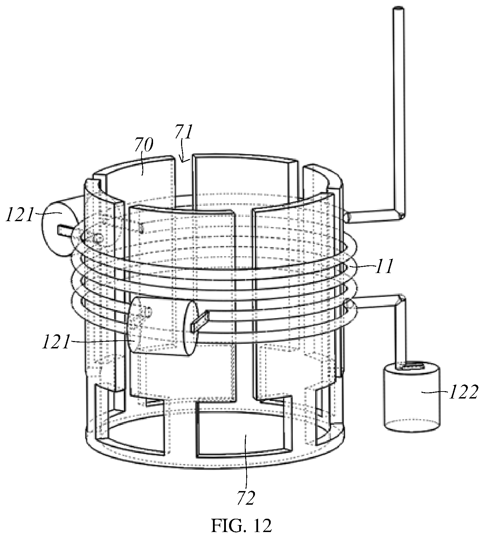

As shown in FIG. 12 and FIG. 13, the radio frequency coil 11 is divided into three coil sections. A total inductance of the radio frequency coil 11 is *L_{coil}*, and can be equally divided into three portions, where an inductance of each section is *L_{coil}*/3. A real-part impedance of loads such as the radio frequency coil 11 is *R*, the second sub-variable capacitor 122 at the second end of the radio frequency coil 11 is *C*₃, and the two first sub-variable capacitors 121 connected in series in the radio frequency coil 11 respectively correspond to *C*₄ and *C*₅ in the schematic diagram. A first tuning capacitor and a second tuning capacitor in the fully automatic matcher (Match) 40 are respectively *C*₁ and *C*₂, and are used for adjusting the rear-end load impedance to impedance output by the radio frequency power supply 30 (for example, 50Ω), so as to ensure maximum power transmission to the rear-end load. Assuming that current flowing into the radio frequency coil 11 is *I*, the source-end voltage of the radio frequency coil 11 is *V*. A voltage-current sensor (Sensor in FIG. 14) is provided at the output end of Match, and can be used for monitoring the potential of the source end of the radio frequency coil 11. The potential of the source end of the radio frequency coil 11 is: $V = I \left(R+{Z}_{coil}+{Z}_{3}+{Z}_{4}+{Z}_{5}\right)$

Wherein, impedance of the radio frequency coil 11 is *Z_{coil}* = *j*ω*L_{coil}*,impedance of the second sub-variable capacitor (that is, *C*₃) 122 is ${Z}_{c 3} = \frac{1}{{jωC}_{3}}$, impedance of the capacitor (that is, one first sub-variable capacitor 121) *C*₄ connected in series with the coil section is ${Z}_{c 4} = \frac{1}{{jωC}_{4}}$, and impedance of the capacitor (that is, another first sub-variable capacitor 121) *C*₅ connected in series with the coil section is ${Z}_{c 5} = \frac{1}{{jωC}_{5}}$.The angular frequency is *ω*=2*πf*, and *f* is a frequency of an output signal of the radio frequency power supply 30. After Match satisfies an impedance matching condition, output power of the radio frequency power supply 30 satisfies *Power*=*I*²*R*, and the potential of the source end of the radio frequency coil 11 is: $V = \sqrt{\frac{Power}{R}} \left(R+{jωL}_{coil}+\frac{1}{{jωC}_{3}}+\frac{1}{{jωC}_{4}}+\frac{1}{{jωC}_{5}}\right)$

In an inductively coupled plasma source, if the structure of the radio frequency coil 11 remains unchanged, the density of plasma is positively correlated with the current of the radio frequency coil 11. The greater the current of the radio frequency coil 11 is, the higher the plasma density is. After adjustment of capacitance values of the second sub-adjustment capacitor (that is, *C*₃) 122 at the rear end of the radio frequency coil 11 and the two first sub-adjustment capacitors (that is, *C*₄ and *C*₅) 121, and after Match adjusts *C*₁ and *C*₂ for rematching, the current value flowing through the radio frequency coil 11 is almost unchanged, and does not affect the density of the excited plasma, but can change voltage distribution on the radio frequency coil 11. By reducing the average potential and the maximum potential on the radio frequency coil 11, capacitive coupling can be reduced, and the electric field in the sheath region can be reduced, such that bombardment of the plasma generation chamber 20 by plasma accelerated through the electric field is weakened.

If the structure of the radio frequency coil 11 remains unchanged, impedance *Z_{coil}* ,of the radio frequency coil 11 remains unchanged; changing magnitudes of *C*₃ and *C*₄ and *C*₅ does not affect the current flowing through the radio frequency coil 11, and thus the potential difference Δ*V* between two ends of the radio frequency coil 11 is basically the same, and is uniformly denoted herein as: $Δ V = I ⋅ {jωL}_{coil} = 2 {V}_{0}$

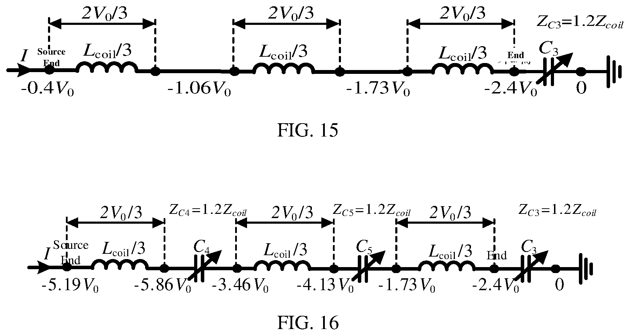

Under the same radio frequency power, the potential difference between two ends of the radio frequency coil 11 is 2*V*₀. In the structure shown in FIG. 15, the radio frequency coil 11 is equally divided into three coil sections, and the potential of each coil section decreases to 2*V*₀/3≈0.67*V*₀. When the structure in which the variable capacitor 12 is only distributed between the second end of the radio frequency coil 11 and ground is in the ignition stage, potential distribution of the radio frequency coil 11 is as shown in FIG. 15, and the corresponding impedance value Z_{C3} of the variable capacitor 12 of the radio frequency coil 11 is *Z_{C3}*=1.2*Z_{coil}*. Then, a maximum potential amplitude on the radio frequency coil 11 is 2.4*V*₀.

When the structure in which the variable capacitor 12 includes two first sub-variable capacitors 121 and the second sub-variable capacitor 122 is in the ignition stage, potential distribution of the radio frequency coil 11 is as shown in FIG. 16. The impedance value of the second sub-variable capacitor 122 connected to the radio frequency coil 11 is *Z*_{*C*3}=1.2*Z_{coil}*, and impedance values of the two first sub-variable capacitors 121 are respectively *Z*_{*C*4} and *Z*_{*C*5}, where *Z*_{*C*4}= *Z*_{*C*5}=1.2*Z_{coil}*. Then, the maximum potential amplitude on the radio frequency coil 11 is 5.86*V*₀. Thus, it can be seen that, compared with the structure of the upper electrode device 10 shown in FIG. 15, the structure shown in FIG. 16 can enable the radio frequency coil 11 to obtain a higher potential at an ignition instant, and the electric field coupled into the plasma generation chamber 20 is stronger, thereby being more beneficial to ignition and completion of glow discharge initiation (that is, completion of ignition).

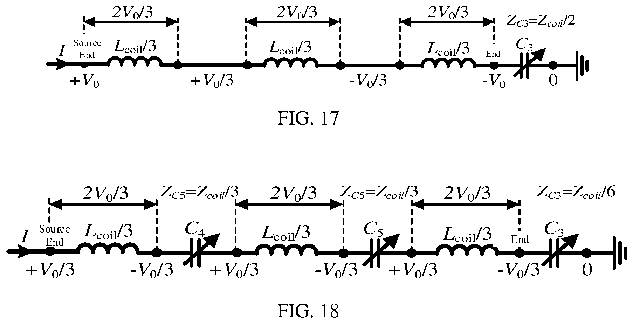

When the variable capacitor 12 is only distributed between the second end of the radio frequency coil 11 and ground, in the process stage, potential distribution of the radio frequency coil 11 is as shown in FIG. 17, and the impedance value of the variable capacitor 12 of the radio frequency coil 11 is *Z*_{*C*3}=0.5*Z_{coil}*, such that the maximum potential amplitude on the radio frequency coil 11 is V₀. When the structure in which the variable capacitor 12 includes two first sub-variable capacitors 121 and the second sub-variable capacitor 122 is in the process stage, potential distribution of the radio frequency coil 11 is as shown in FIG. 18, and the impedance value of the second sub-variable capacitor 122 of the radio frequency coil 11 is *Z*_{*C*3}=*Z_{coil}*/6. Impedance values of the two first sub-variable capacitors 121 are respectively *Z*_{*C*4} and *Z*_{*C*5}, where *Z*_{*C*4}=*Z*_{*C*5}= *Z_{coil}*/3, such that the maximum potential amplitude on the radio frequency coil 11 is *V*₀/3. Compared with the structure shown in FIG. 17, the structure shown in FIG. 18 can enable the radio frequency coil 11 to obtain a lower potential in the process stage, thereby causing the electric field coupled by the radio frequency coil 11 into the plasma generation chamber 20 to be weaker, and being more beneficial to maintaining relatively low damage to the plasma generation chamber 20 during the process.

According to this characteristic, an ignition flow as shown in FIG. 19 can be designed. Before loading power, *C*₃, *C*₄, and *C*₅ are adjusted to satisfy *Z*_{*C*3}=*Z*_{*C*4}=*Z*_{*C*5}=1.2*Z_{coil}*>*Z_{coil}*. Under this condition, the overall potential of the radio frequency coil 11 is relatively high. After gas introduction and pressure control are performed in the chamber (that is, the plasma generation chamber 20), radio frequency power is loaded, and *C*₁ and *C*₂ of Match are adjusted to perform impedance matching, such that the radio frequency power is loaded onto loads such as the radio frequency coil 11. At this time, the electric field coupled by the radio frequency coil 11 into the plasma generation chamber 20 is relatively strong, which is beneficial to ignition.

A manner for determining whether ignition is successful is as follows: a voltage-current sensor (that is, Sensor in the figure) is mounted at the output end of Match, and voltage *V*₁ of static impedance at an ignition instant and voltage *V*₂ after glow discharge initiation (that is, after ignition is successful) are collected in advance through manual testing. Since *V*₂ is obviously less than *V*₁, a voltage threshold *V*₀=0.5*V*₁+0.5*V*₂ can be specified. At the ignition instant, Sensor reads voltage *V*. If *V* drops from being greater than *V*₀ to being less than *V*₀, ignition is considered successful. If ignition fails, values of *C*₃, *C*₄, and *C*₅ continue to be reduced (for example, capacitance values obtained after multiplying current values of *C*₃, *C*₄, and *C*₅ by 0.9 are used as adjusted capacitance values of *C*₃, *C*₄, and *C*₅, which is equivalent to impedance values obtained after multiplying current *Z*_{*C*3}, *Z*_{*C*4}, and *Z*_{*C*5} by a preset coefficient greater than 1 being used as adjusted impedance values of *Z*_{*C*3}, *Z*_{*C*4}, and *Z*_{*C*5}), and matching is performed again until ignition is successful.

After ignition is successful, *C*₃, *C*₄, and *C*₅ are adjusted again, such that the impedance value of *C*₃ satisfies *Z*_{*C*3}=*Z_{coil}*/6, and impedance values *Z*_{*C*4} and *Z*_{*C*5} respectively corresponding to capacitance values of *C₄* and *C₅* satisfy *Z*_{*C*4}= *Z*_{*C*5}=*Z_{coil}*/3. In this case, the overall potential of the radio frequency coil 11 is lowest. Next, Match adjusts *C*₁ and *C*₂ to perform impedance matching, such that the radio frequency power is completely loaded again onto loads such as the radio frequency coil 11, thereby completing ignition and entering the process stage.

In the embodiments of the present disclosure, there can be multiple manners for adjusting the capacitance value of the variable capacitor 12. Certainly, any capacitor capable of adjusting the capacitance value can serve as the variable capacitor 12. In a solution of one embodiment, the upper electrode device 10 disclosed in the embodiments of the present disclosure can further include a driving mechanism 13. The variable capacitor 12 can include a first capacitor plate and a second capacitor plate. The driving mechanism 13 can be connected to at least one of the first capacitor plate and the second capacitor plate. The driving mechanism 13 is used for driving at least one of the first capacitor plate and the second capacitor plate to move, so as to adjust at least one of a distance and a relative area between the first capacitor plate and the second capacitor plate, thereby adjusting the capacitance value of the variable capacitor 12. For example, the driving mechanism 13 is connected to the first capacitor plate or the second capacitor plate through a power connection shaft, thereby adjusting rotation or movement of the first capacitor plate or the second capacitor plate, thereby achieving a purpose of adjusting the capacitance value. The manner of adjusting the capacitance value of the variable capacitor 12 by using the driving mechanism 13 can more quickly achieve a purpose of adjusting the voltage of the radio frequency coil 11. Compared with up-and-down adjustment of the radio frequency coil 11, the manner of using the driving mechanism 13 in cooperation with the variable capacitor 12 can more quickly achieve successful ignition, thereby being beneficial to improving productivity.

Certainly, when the variable capacitor 12 includes the first sub-variable capacitor 121, the process chamber can configure a corresponding driving mechanism for the first sub-variable capacitor 121, such that the driving mechanism adjusts the capacitance value of the first sub-variable capacitor 121 by driving at least one of two capacitor plates of the first sub-variable capacitor 121 to move. When the variable capacitor 12 includes the second sub-variable capacitor 122, the process chamber can also configure a corresponding driving mechanism for the second sub-variable capacitor 122, such that the driving mechanism adjusts the capacitance value of the second sub-variable capacitor 122 by driving at least one of two capacitor plates of the second sub-variable capacitor 122 to move.

As described above, the shielding cylinder 70 can have multiple structures, and the shielding cylinder 70 is an openwork hollow cylindrical member. Specifically, the shielding cylinder 70 can be provided with a plurality of slots 71 extending along an axial direction of the shielding cylinder 70. The plurality of slots 71 are distributed at intervals along a circumferential direction of the shielding cylinder 70, and the plurality of slots 71 can be uniformly distributed along the circumferential direction of the shielding cylinder 70, thereby facilitating the radio frequency coil 11 to couple a relatively uniform magnetic field into the plasma generation chamber 20 through the shielding cylinder 70 relatively uniformly, thereby being relatively beneficial to enabling plasma generated in the plasma generation chamber 20 to satisfy process requirements. The number of the slots 71 can be 6, or can be 4 or 8. The embodiments of the present disclosure do not limit a specific number of the slots 71.

Widths of various portions of the slot 71 can be equal. In other words, a width of the slot 71 at two end positions in an axial direction thereof can be equal to a width of any region between the two ends of the slot 71, where a width direction of the slot 71 is a circumferential direction of the shielding cylinder 70. However, this is not restrictive. In other embodiments, widths at the two end positions in the axial direction of the slot 71 can be greater than a width at a preset position between the two ends of the slot 71. The radio frequency coil 11 is wound on an outer peripheral side of the shielding cylinder 70 and is located at the preset position of the slot 71 in the axial direction. As described above, after the impedance adjustment member 12 is adjusted, voltage distribution of the radio frequency coil 11 can be changed, such that voltage on the radio frequency coil 11 can be relatively large in the ignition stage, thereby enabling the radio frequency coil 11 to couple a relatively large electric field into the plasma generation chamber 20, and ultimately ensuring relatively easy ignition even if the width of the slot 71 is relatively small. In this embodiment, the radio frequency coil 11 is wound at the preset position between the two ends of the slot 71 where the width is relatively small. Since the width of the slot 71 at the preset position is smaller than widths at the two ends of the slot 71, the electric field of the radio frequency coil 11 can be better shielded in the process stage, coupling of the electric field into the plasma generation chamber 20 in the process stage can be reduced as much as possible, and meanwhile it can also be ensured that the magnetic field is coupled from the shielding cylinder 70 into the plasma generation chamber 20 without loss.

Certainly, since the radio frequency coil 11 is wound at the preset position between the two ends of the slot 71, and considering magnetic field distribution of the radio frequency coil 11, widths at the two ends of the slot 71 are relatively large, thereby more easily enabling the magnetic field generated by the radio frequency coil 11 to be coupled into the plasma generation chamber 20.

It should be noted that, in this embodiment, distances from the radio frequency coil 11 to the two ends of the slot 71 in the axial direction can be equal or unequal. In some other embodiments not shown in the figures, the radio frequency coil 11 can also be relatively close to one end of the slot 71 and relatively far from the other end in the axial direction, which is not limited herein.

In a further technical solution, the shielding cylinder 70 can further be provided with a plurality of flared windows 72. The plurality of flared windows 72 are correspondingly in communication with axial end portions of the plurality of slots 71, for example, in one-to-one corresponding communication. Dimensions of the plurality of flared windows 72 in the width direction of the slots 71 are greater than widths of the corresponding slots 71. That is, dimensions of the plurality of flared windows 72 in the circumferential direction of the shielding cylinder 70 are greater than dimensions of the corresponding slots 71 in the circumferential direction of the shielding cylinder 70. In this case, since a bottom end of the shielding cylinder 70 is used for grounding, an opening at the bottom end of the shielding cylinder 70 is relatively easily blocked (for example, easily blocked by the shielding box 80 described below). The flared windows 72 can ensure that the magnetic field generated by the radio frequency coil 11 is sufficiently coupled into the plasma generation chamber 20 through the flared windows 72, thereby ensuring an inductive coupling effect.

As described above, the shielding cylinder 70 is used for grounding, thereby ensuring that the potential of the shielding cylinder 70 is relatively low, reducing a potential difference between the shielding cylinder 70 and plasma, and thereby avoiding bombardment of the plasma generation chamber 20 by plasma. In optional embodiments, the shielding cylinder 70 can include a plurality of grounding portions. The plurality of grounding portions are located at an end portion of the shielding cylinder 70, and can be uniformly distributed along a circumferential direction of the shielding cylinder 70. By designing a plurality of grounding portions uniformly distributed in the circumferential direction, the shielding cylinder 70 can realize multi-point symmetrical grounding, thereby relatively evenly realizing grounding, and ultimately ensuring symmetry of a return path, so as to ensure uniformity of the electromagnetic field coupled into the plasma generation chamber 20. The plurality of grounding portions can be located at a lower bottom end of the shielding cylinder 70, or can be located at a higher top end of the shielding cylinder 70, which is not limited in the embodiments of the present disclosure.

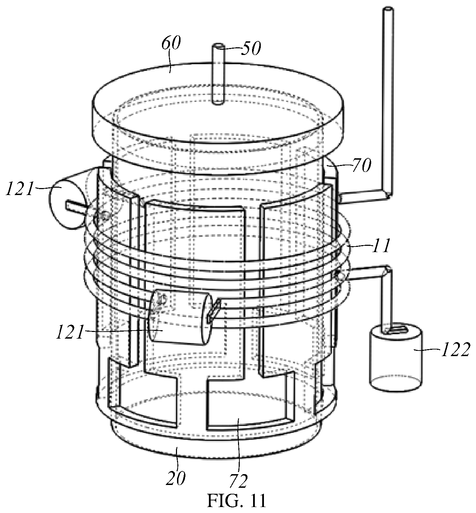

Certainly, as described above, when the variable capacitor 12 includes the first sub-variable capacitor 121, or when the variable capacitor 12 includes the first sub-variable capacitor 121 and the second sub-variable capacitor 122, since the shielding cylinder 70 is provided with a plurality of slots 71 distributed at intervals along the circumferential direction of the shielding cylinder 70, in this case, the first sub-variable capacitor 121 and the second sub-variable capacitor 122 may be opposite to the slots 71, thereby easily causing angular asymmetry of the electromagnetic field. Based on this, the shielding cylinder is provided with a plurality of slots distributed at intervals along the circumferential direction of the shielding cylinder, and the first sub-impedance adjustment member and the second sub-impedance adjustment member are both distributed in a staggered manner relative to the slots. In one embodiment, by taking the variable capacitor 12 including the first sub-variable capacitor 121 as an example, the first sub-variable capacitor 121 can be distributed in a staggered manner relative to the slots 71. That is, the first sub-variable capacitor 121 (that is, the first sub-impedance adjustment member) can avoid positions of the slots 71 and be located between two adjacent slots 71. Certainly, when the variable capacitor 12 includes the second sub-variable capacitor 122, the second sub-variable capacitor 122 can also be distributed in a staggered manner relative to the slots 71. That is, the second sub-variable capacitor 122 (that is, the second sub-impedance adjustment member) can also avoid positions of the slots 71 and be located between two adjacent slots 71, as shown in FIG. 10 and FIG. 11. This staggered distribution manner almost does not cause eccentricity of a process result due to discontinuity of the radio frequency coil 11.

The process chamber disclosed in the embodiments of the present disclosure can further include a shielding box 80, and the shielding box 80 is used for grounding. The second end of the radio frequency coil 11 is electrically connected with the shielding box 80, thereby realizing grounding. The plasma generation chamber 20, the shielding cylinder 70, the radio frequency coil 11, and the variable capacitor 12 can be disposed inside the shielding box 80, thereby being protected by the shielding box 80, and meanwhile avoiding interference, caused by a magnetic field that may exist in an external environment, to the magnetic field generated by the radio frequency coil 11. The shielding cylinder 70 is electrically connected with the shielding box 80, thereby realizing grounding. In the embodiments of the present disclosure, the shielding cylinder 70 and the shielding box 80 can both be made of metal.

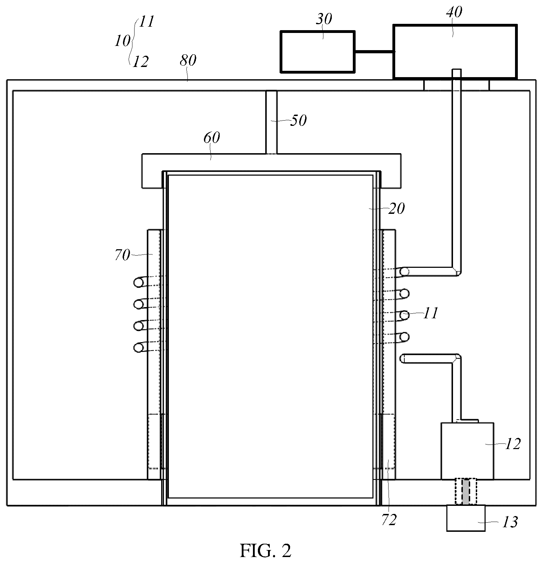

When the process chamber includes the driving mechanism 13, as shown in FIG. 1 and FIG. 2, in optional embodiments, the driving mechanism 13 can be mounted outside the shielding box 80, and connected through a connection shaft with the variable capacitor 12 disposed inside the shielding box 80. This arrangement manner can mitigate adverse influence, easily caused by the driving mechanism 13 being located inside the shielding box 80, on the magnetic field generated by the radio frequency coil 11. That is, since the driving mechanism 13 is located outside the shielding box 80, compared with disposing the driving mechanism 13 inside the shielding box 80, influence caused by the driving mechanism 13 on the magnetic field generated by the radio frequency coil 11 can be mitigated.

In a further embodiment, the radio frequency power supply 30 and the matcher 40 can be located outside the shielding box 80, and mounted on the shielding box 80. In this case, the shielding box 80 can further provide mounting positions for the radio frequency power supply 30 and the matcher 40. Certainly, the radio frequency power supply 30 and the matcher 40 are located outside the shielding box 80, thereby avoiding adverse influence on components inside the shielding box 80.

Based on the process chamber disclosed in the embodiments of the present disclosure, the embodiments of the present disclosure further provide a semiconductor process equipment. The disclosed semiconductor process equipment includes a controller and the process chamber according to any one of the above embodiments. The controller includes a memory and a processor. The memory stores a computer program. The processor executes the following operations according to the computer program:
Adjusting the impedance adjustment member to a first preset impedance value;
Loading radio frequency power onto the radio frequency coil 11, and determining whether ignition is successful;
When ignition is successful, adjusting the impedance adjustment member to a second preset impedance value, where the second preset impedance value is less than the first preset impedance value.

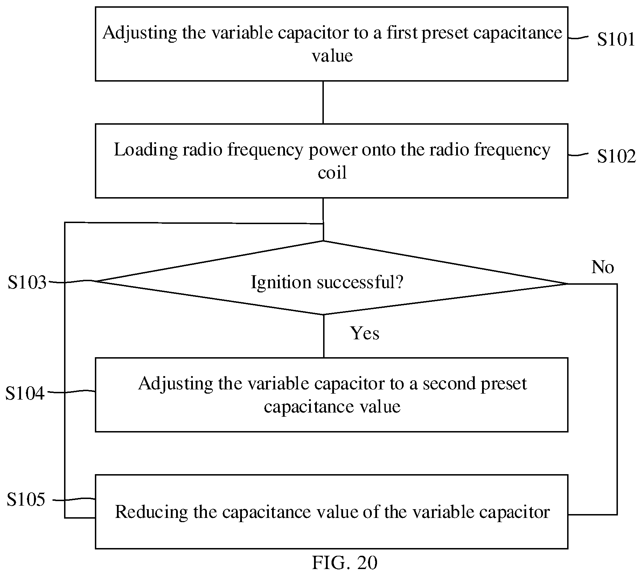

As shown in FIG. 20, by taking the impedance adjustment member being the variable capacitor 12 as an example, at S101, the variable capacitor 12 is adjusted to a first preset capacitance value, thereby causing the impedance value of the variable capacitor 12 to be correspondingly adjusted to the first preset impedance value.

In one embodiment, when the variable capacitor 12 is only connected between the second end of the radio frequency coil 11 and ground, in this operation, the capacitance value of the variable capacitor 12 can be adjusted to a first preset capacitance value, such that the impedance value of the variable capacitor 12 is greater than *Z_{coil}*, for example, 1.2*Z_{coil}*, thereby causing the radio frequency coil 11 to have a relatively high potential after radio frequency power is loaded.

In another embodiment, when the variable capacitor 12 includes the above two first sub-variable capacitors 121 and one second sub-variable capacitor 122, in this operation, capacitance values of the two first sub-variable capacitors (that is, *C₄* and *C₅*) 121 and the second sub-variable capacitor (that is, *C₃*) 122 can be respectively adjusted to first preset capacitance values, such that the impedance value of the second sub-variable capacitor 122 and impedance values of the two first sub-variable capacitors 121 can both be greater than *Z_{coil}*, for example, 1.2*Z_{coil}*, thereby causing the radio frequency coil 11 to have a relatively high potential after radio frequency power is loaded.

At S102, radio frequency power is loaded onto the radio frequency coil 11.

Certainly, before radio frequency power is loaded, process gas also needs to be introduced into the plasma generation chamber 20 and air pressure in the plasma generation chamber 20 needs to be controlled. After the radio frequency power is loaded, the matcher 40 automatically adjusts its own *C₁* (that is, the first tuning capacitor of the matcher 40) and *C₂* (that is, the second tuning capacitor of the matcher 40) to perform impedance matching, such that the radio frequency power is loaded onto loads such as the radio frequency coil 11.

At S103, whether ignition is successful is determined.

At S104, when ignition is successful, the variable capacitor 12 is adjusted to a second preset capacitance value, thereby causing the impedance value of the variable capacitor 12 to be correspondingly adjusted to a second preset impedance value.

In one embodiment, when the variable capacitor 12 is only connected between the second end of the radio frequency coil 11 and ground, in this operation, the capacitance value of the variable capacitor (that is, *C₃*) 12 can be adjusted to a second preset capacitance value, such that the impedance value of the variable capacitor 12 is 0.5*Z_{coil}*, thereby causing the potential of the radio frequency coil 11 to be relatively low. Wherein, the second preset capacitance value is greater than the first preset capacitance value, that is, the second preset impedance value is less than the first preset impedance value.

In another embodiment, when the variable capacitor 12 includes the above two first sub-variable capacitors 121 and one second sub-variable capacitor 122, in this operation, capacitance values of the two first sub-variable capacitors (that is, *C₄* and *C₅*) 121 and the second sub-variable capacitor (that is, *C₃*) 122 can be respectively adjusted, such that the impedance value of the second sub-variable capacitor 122 is *Z_{coil}*/6, and impedance values of the two first sub-variable capacitors 121 can both be *Z_{coil}*/3, thereby causing the radio frequency coil 11 to have a relatively low potential after radio frequency power is loaded.

Certainly, after S104, the matcher 40 can also be controlled to automatically adjust its own *C₁* and *C₂* to perform impedance matching, such that the radio frequency power is loaded onto loads such as the radio frequency coil 11.

It should be noted that *C₃* involved in the embodiments of the present disclosure can be considered as a portion of the variable capacitor 12 connected between the second end of the radio frequency coil 11 and ground. When the variable capacitor 12 is a capacitor only connected between the second end of the radio frequency coil 11 and ground, adjustment of *C₃* can be considered as adjustment of the variable capacitor 12 as a whole. When the variable capacitor 12 includes the first sub-variable capacitor 121 and the second sub-variable capacitor 122, adjustment of *C₃* can be considered as adjustment of the second sub-variable capacitor 122 of the variable capacitor 12. Certainly, when the variable capacitor 12 includes the first sub-variable capacitor 121 and the second sub-variable capacitor 122, adjustment of the variable capacitor 12 requires adjustment of the first sub-variable capacitor 121 and the second sub-variable capacitor 122.

Further, when ignition is unsuccessful, the impedance value of the impedance adjustment member 12 is adjusted, and the operation of determining whether ignition is successful is restarted.

As shown in FIG. 20, still by taking the impedance adjustment member being the variable capacitor 12 as an example, at S105, when ignition is unsuccessful, the capacitance value of the variable capacitor 12 is reduced, that is, the impedance value of the variable capacitor is increased, and the operation of determining whether ignition is successful is restarted.

In this operation, for example, a current capacitance value of the variable capacitor 12 can be multiplied by a preset coefficient and used as an adjusted capacitance value for reduction. The preset coefficient is less than 1, for example, the preset coefficient can be 0.9. An adjusted result is equivalent to increasing a current impedance value of the impedance adjustment member by multiplying the current impedance value thereof by a preset coefficient greater than 1 and using a resulting impedance value as an adjusted impedance value, as shown in FIG. 9. Certainly, the embodiments of the present disclosure do not limit a specific magnitude of the preset coefficient, as long as the preset coefficient is less than 1. Similarly, when the variable capacitor 12 includes the first sub-variable capacitor 121 and the second sub-variable capacitor 122, reducing the capacitance value of the variable capacitor 12 requires respectively multiplying the first sub-variable capacitor 121 and the second sub-variable capacitor 122 by preset coefficients less than 1 (for example, 0.9), and using resulting capacitance values as adjusted capacitance values for adjustment, which is equivalent to respectively multiplying impedance values of the first sub-impedance adjustment member and the second sub-impedance adjustment member by preset coefficients greater than 1 and using resulting impedance values as adjusted impedance values, as shown in FIG. 19.

Please refer to FIG. 9. In one embodiment, still by taking the impedance adjustment member being the variable capacitor 12 as an example, there can be at least one variable capacitor 12, where:
Adjusting the variable capacitor 12 to the first preset capacitance value includes: adjusting the variable capacitor 12 to the first preset capacitance value, such that the impedance value of the variable capacitor 12 is greater than the impedance value of the radio frequency coil 11, for example, 1.2*Z_{coil}*; that is, by adjusting the variable capacitor 12 to the first preset capacitance value, the impedance value thereof is correspondingly adjusted to the first preset impedance value, thereby causing the impedance value of the variable capacitor 12 to be greater than the impedance value of the radio frequency coil 11;
Between loading radio frequency power onto the radio frequency coil 11 and determining whether ignition is successful, the processor further executes: adjusting the first tuning capacitor and the second tuning capacitor of the matcher of the semiconductor process equipment to perform impedance matching, such that the radio frequency power is at least loaded onto the radio frequency coil 11;
When ignition is successful, adjusting the variable capacitor 12 to the second preset capacitance value includes: increasing the capacitance value of the variable capacitor 12 to the second preset capacitance value, such that the impedance value of the variable capacitor 12 is greater than 0 and less than the impedance value of the radio frequency coil 11, for example, 0.5*Z_{coil}*; that is, by adjusting the variable capacitor 12 to the second preset capacitance value, the impedance value thereof is correspondingly adjusted to the second preset impedance value, thereby causing the impedance value of the variable capacitor 12 to be less than the impedance value of the radio frequency coil 11;
After the variable capacitor 12 is adjusted to the second preset capacitance value, the processor further executes: adjusting the first tuning capacitor and the second tuning capacitor of the matcher to perform impedance matching, such that the radio frequency power is at least loaded onto the radio frequency coil 11;
When ignition is unsuccessful, reducing the capacitance value of the variable capacitor 12 includes: multiplying a current capacitance value of the variable capacitor 12 by a preset coefficient (for example, 0.9), and using a resulting capacitance value as a reduced capacitance value of the variable capacitor 12, where the preset coefficient is less than 1. That is, when ignition is unsuccessful, the impedance value of the variable capacitor 12 is increased by reducing the capacitance value of the variable capacitor 12. Wherein, multiplying the current capacitance value of the variable capacitor 12 by a preset coefficient (for example, 0.9) and using a resulting capacitance value as the reduced capacitance value of the variable capacitor 12 is equivalent to multiplying the current impedance value of the variable capacitor 12 by a preset coefficient greater than 1 and using a resulting impedance value as an increased impedance value of the variable capacitor 12. Please refer to FIG. 19. In another embodiment, the variable capacitor 12 can, for example, include two first sub-variable capacitors 121 and one second sub-variable capacitor 122. The radio frequency coil 11 can include at least two coil sections connected in series. Each first sub-variable capacitor 121 can be connected in series between two adjacent coil sections, and the second sub-variable capacitor 122 is configured to be connected between the second end of the radio frequency coil 11 and ground. As described above, more first sub-variable capacitors 121 can be provided;
Adjusting the variable capacitor 12 to the first preset capacitance value includes: adjusting capacitance values of the two first sub-variable capacitors 121 and the one second sub-variable capacitor 122, such that impedance values of the two first sub-variable capacitors 121 and the one second sub-variable capacitor 122 are greater than the impedance value of the radio frequency coil 11, for example, 1.2*Z_{coil}*; that is, capacitance values of the two first sub-variable capacitors 121 and the one second sub-variable capacitor 122 are adjusted, such that respective impedance values thereof are correspondingly changed, thereby causing the impedance values of the two first sub-variable capacitors 121 and the one second sub-variable capacitor 122 to be greater than the impedance value of the radio frequency coil 11;
Between loading radio frequency power onto the radio frequency coil 11 and determining whether ignition is successful, the processor further executes: adjusting the first tuning capacitor and the second tuning capacitor of the matcher of the semiconductor process equipment to perform impedance matching, such that the radio frequency power is at least loaded onto the radio frequency coil 11;
When ignition is successful, adjusting the variable capacitor 12 to the second preset capacitance value includes: increasing capacitance values of the two first sub-variable capacitors 121 and the second sub-variable capacitor 122, such that impedance values of the two first sub-variable capacitors 121 are Z_{coil}/3, and the impedance value of the second sub-variable capacitor 122 is Z_{coil}/6, where Z_{coil} is the impedance value of the radio frequency coil 11; more generally, the impedance value of each first sub-variable capacitor 121 is Z_{coil}/n, and the impedance value of the second sub-variable capacitor 122 is Z_{coil}/2n, where n is a sum of the number of the first sub-variable capacitors 121 and the number of the second sub-variable capacitor 122.

After the variable capacitor 12 is adjusted to the second preset capacitance value, the processor further executes: adjusting the first tuning capacitor and the second tuning capacitor of the matcher to perform impedance matching, such that the radio frequency power is at least loaded onto the radio frequency coil 11.

When ignition is unsuccessful, reducing the capacitance value of the variable capacitor 12 includes: multiplying current capacitance values of the two first sub-variable capacitors 121 and the second sub-variable capacitor 122 by a preset coefficient, and using resulting capacitance values as reduced capacitance values of the two first sub-variable capacitors 121 and the second sub-variable capacitor 122, where the preset coefficient is less than 1. That is, when ignition is unsuccessful, the impedance value of the variable capacitor 12 is increased by reducing the capacitance value of the variable capacitor 12. Wherein, multiplying the current capacitance values of the two first sub-variable capacitors 121 and the second sub-variable capacitor 122 by a preset coefficient less than 1 and using resulting capacitance values as reduced capacitance values of the two first sub-variable capacitors 121 and the second sub-variable capacitor 122 is equivalent to multiplying current impedance values of the two first sub-variable capacitors 121 and the second sub-variable capacitor 122 by a preset coefficient greater than 1 and using resulting impedance values as increased impedance values of the two first sub-variable capacitors 121 and the second sub-variable capacitor 122.

It should be noted that, in the above exemplary examples, the L-type matcher performs impedance matching by adjusting the first tuning capacitor and the second tuning capacitor. However, this is not restrictive. The matcher can also adopt other models, and any matcher capable of realizing impedance matching falls within the protection scope of the present disclosure.

The above embodiments of the present disclosure mainly describe differences among various embodiments. As long as different technical features of the various embodiments are not contradictory, the different technical features can be combined to form more specific embodiments. Considering conciseness of description, details are not repeated herein.

The embodiments of the present disclosure have been described above in conjunction with the accompanying drawings. However, the present disclosure is not limited to the above specific implementations. The above specific implementations are merely illustrative rather than restrictive. Under enlightenment of the present disclosure, those of ordinary skill in the art can still make many forms without departing from the purpose of the present disclosure and the scope protected by the claims, and all such forms fall within the protection scope of the present disclosure.

## Claims

1. An upper electrode device for a process chamber, comprising a radio frequency coil and an impedance adjustment member, wherein the radio frequency coil is configured to be wound outside a shielding cylinder of the process chamber, and the shielding cylinder is sleeved outside a plasma generation chamber of the process chamber; the impedance adjustment member is connected in series with the radio frequency coil, and the impedance adjustment member is configured to be adjusted to different impedance values in an ignition stage and a reaction stage of the process chamber.

2. The upper electrode device according to claim 1, wherein a first end of the radio frequency coil is configured for electrical connection to a radio frequency power supply of the process chamber, and a second end of the radio frequency coil is used for grounding through the impedance adjustment member.

3. The upper electrode device according to claim 2, wherein the impedance adjustment member is at least one, an impedance value of the impedance adjustment member in the ignition stage is greater than Z_{coil}, the Z_{coil} is an impedance value of the radio frequency coil, and the impedance value of the impedance adjustment member in the reaction stage is greater than 0 and less than Z_{coil}; or,
the impedance value of the impedance adjustment member in the reaction stage is greater than 0.4Z_{coil} and less than 0.6Z_{coil}; or,
the impedance value of the impedance adjustment member in the reaction stage is equal to 0.5Z_{coil}.

4. The upper electrode device according to claim 1, wherein the first end of the radio frequency coil is configured to connect to a radio frequency power supply of the process chamber, the second end of the radio frequency coil is used for grounding, the impedance adjustment member comprises at least one first sub-impedance adjustment member, the radio frequency coil comprises at least two coil sections connected in series, and each first sub-impedance adjustment member is connected in series between two adjacent coil sections.

5. The upper electrode device according to claim 4, wherein the impedance adjustment member further comprises a second sub-impedance adjustment member, and the second sub-impedance adjustment member is configured to connect the second end of the radio frequency coil and ground.

6. The upper electrode device according to claim 5, wherein, in the ignition stage, impedance values of the first sub-impedance adjustment member and the second sub-impedance adjustment member are both greater than Z_{coil}, and the Z_{coil} is the impedance value of the radio frequency coil;
in the reaction stage, the impedance values of the first sub-impedance adjustment member and the second sub-impedance adjustment member are both greater than 0 and less than Z_{coil}.

7. The upper electrode device according to claim 5, wherein the first sub-impedance adjustment members are multiple, impedance values of the first sub-impedance adjustment members are all equal, and are greater than the impedance value of the second sub-impedance adjustment member.

8. The upper electrode device according to claim 5, wherein the impedance value of the first sub-impedance adjustment member is Z_{coil}/n, and the impedance value of the second sub-impedance adjustment member is Z_{coil}/2n, wherein n is a sum of the number of the first sub-impedance adjustment members and the number of the second sub-impedance adjustment members.

9. The upper electrode device according to claim 5, wherein the shielding cylinder is provided with a plurality of slots extending along an axial direction of the shielding cylinder, the plurality of slots are distributed at intervals along a circumferential direction of the shielding cylinder, and the first sub-impedance adjustment member and the second sub-impedance adjustment member are both distributed in a staggered manner relative to the slots.

10. The upper electrode device according to claim 1, wherein the upper electrode device further comprises a driving mechanism, the impedance adjustment member comprises a first capacitor plate and a second capacitor plate, the driving mechanism is connected to at least one of the first capacitor plate and the second capacitor plate, and the driving mechanism is configured to drive at least one of the first capacitor plate and the second capacitor plate to move, to adjust at least one of a distance and a relative area between the first capacitor plate and the second capacitor plate to adjust a capacitance value of the impedance adjustment member.

11. The upper electrode device according to claim 1, wherein the shielding cylinder is provided with a plurality of slots extending along an axial direction of the shielding cylinder, the plurality of slots are uniformly distributed at intervals along a circumferential direction of the shielding cylinder, a width of the slot at two end positions in the axial direction thereof is greater than a width of a preset position between the two ends, and the radio frequency coil is wound on an outer peripheral side of the shielding cylinder and is located at the preset position of the slot in the axial direction.

12. The upper electrode device according to claim 1, wherein the shielding cylinder is provided with a plurality of slots extending along an axial direction of the shielding cylinder, the plurality of slots are uniformly distributed at intervals along a circumferential direction of the shielding cylinder, the shielding cylinder is provided with a plurality of flared windows, the plurality of flared windows are correspondingly in communication with axial end portions of the plurality of slots, and dimensions of the plurality of flared windows in the circumferential direction of the shielding cylinder are greater than dimensions of the slots in the circumferential direction of the shielding cylinder.

13. The upper electrode device according to claim 1, wherein the shielding cylinder comprises a plurality of grounding portions, the plurality of grounding portions are located at a bottom end of the shielding cylinder, and are uniformly distributed along a circumferential direction of the shielding cylinder.

14. A process chamber, comprising a plasma generation chamber, a process reaction chamber, a shielding cylinder, and the upper electrode device according to any one of claims 1 to 13, wherein the process reaction chamber is in communication with the plasma generation chamber.

15. The process chamber according to claim 14, wherein the process chamber further comprises a shielding box, the plasma generation chamber, the shielding cylinder, the radio frequency coil, and the impedance adjustment member are all disposed inside the shielding box, and the shielding cylinder is electrically connected with the shielding box for grounding.

16. The process chamber according to claim 15, wherein the process chamber further comprises a radio frequency power supply and a matcher, the radio frequency power supply is electrically connected with the first end of the radio frequency coil through the matcher, and the radio frequency power supply and the matcher are located outside the shielding box and are mounted on the shielding box.

17. A semiconductor process equipment, comprising a controller and the process chamber according to any one of claims 14 to 16, wherein the controller comprises a memory and a processor, the memory stores a computer program, and the processor executes the following operations according to the computer program:
adjusting the impedance adjustment member to a first preset impedance value; loading radio frequency power onto the radio frequency coil, and determining whether ignition is successful;
when ignition is successful, adjusting the impedance adjustment member to a second preset impedance value, wherein the second preset impedance value is less than the first preset impedance value.

18. The semiconductor process equipment according to claim 17, wherein the processor further executes the following operations according to the computer program:
when ignition is unsuccessful, increasing the impedance value of the impedance adjustment member and restarting the operation of determining whether ignition is successful.

19. The semiconductor process equipment according to claim 17, wherein the impedance adjustment member is at least one, wherein:
the adjusting the impedance adjustment member to the first preset impedance value comprises: adjusting the impedance adjustment member to the first preset impedance value, such that the impedance value of the impedance adjustment member is greater than the impedance value of the radio frequency coil;
between the loading radio frequency power onto the radio frequency coil and the determining whether ignition is successful, the processor further executes: adjusting the matcher of the semiconductor process equipment to perform impedance matching, such that the radio frequency power is at least loaded onto the radio frequency coil;
when ignition is successful, adjusting the impedance adjustment member to the second preset impedance value comprises: reducing the impedance value of the impedance adjustment member to the second preset impedance value, such that the impedance value of the impedance adjustment member is greater than 0 and less than the impedance value of the radio frequency coil;
after the impedance adjustment member is adjusted to the second preset impedance value, the processor further executes: adjusting the matcher to perform impedance matching, such that the radio frequency power is at least loaded onto the radio frequency coil; or
the processor is further used for executing: when ignition is unsuccessful, increasing the impedance value of the impedance adjustment member, comprising: multiplying a current impedance value of the impedance adjustment member by a preset coefficient and using a resulting impedance value as an increased impedance value of the impedance adjustment member, wherein the preset coefficient is greater than 1.

20. The semiconductor process equipment according to claim 17, wherein the impedance adjustment member comprises a plurality of first sub-impedance adjustment members and one second sub-impedance adjustment member, the radio frequency coil comprises at least two coil sections connected in series, each first sub-impedance adjustment member is connected in series between two adjacent coil sections, and the second sub-impedance adjustment member is configured to be connected between the second end of the radio frequency coil and ground, the adjusting the impedance adjustment member to the first preset impedance value comprises: adjusting impedance values of the plurality of first sub-impedance adjustment members and the one second sub-impedance adjustment member, such that impedance values of each first sub-impedance adjustment member and the one second sub-impedance adjustment member are both greater than the impedance value of the radio frequency coil;
between the loading radio frequency power onto the radio frequency coil and the determining whether ignition is successful, the processor further executes: adjusting the matcher of the semiconductor process equipment to perform impedance matching, such that the radio frequency power is at least loaded onto the radio frequency coil;
when ignition is successful, adjusting the impedance adjustment member to the second preset impedance value comprises: reducing impedance values of the plurality of first sub-impedance adjustment members and the second sub-impedance adjustment member, such that the impedance value of each first sub-impedance adjustment member is Z_{coil}/n, and the impedance value of the second sub-impedance adjustment member is Z_{coil}/2n, wherein the Z_{coil} is the impedance value of the radio frequency coil, and n is a sum of the number of the first sub-impedance adjustment members and the number of the second sub-impedance adjustment member;
after the impedance adjustment member is adjusted to the second preset impedance value, the processor further executes: adjusting the matcher to perform impedance matching, such that the radio frequency power is at least loaded onto the radio frequency coil; or the processor is further used for executing: when ignition is unsuccessful, increasing the impedance values of the impedance adjustment member, comprising: multiplying current impedance values of each first sub-impedance adjustment member and the second sub-impedance adjustment member by a preset coefficient and using resulting impedance values as increased impedance values of each first sub-impedance adjustment member and the second sub-impedance adjustment member, wherein the preset coefficient is greater than 1.
